# EUROPEAN PATENT APPLICATION

(11) **EP 4 357 740 A1**
(43) Date of publication of application: **24.04.2024**
(21) Application number: 22824591.6
(22) Date of filing: 22.03.2022
(51) Int. Cl.: G01H 17/00, H02B 3/00

(54) **ACOUSTIC CIRCUIT BREAKER DIAGNOSIS DEVICE AND METHOD**

(30) Priority: 16.06.2021 JP 2021099874
(71) Applicant: Hitachi, Ltd., Tokyo 100-8280 (JP)
(72) Inventor: ENDO Takashi, Tokyo 100-8280 (JP); IWATA Takeshi, Tokyo 100-8280 (JP); ROKUNOHE Toshiaki, Tokyo 100-8280 (JP); KOYAMA Hikaru, Tokyo 100-8280 (JP); DOHI Kota, Tokyo 100-8280 (JP)
(74) Representative: MERH-IP Matias Erny Reichl Hoffmann Patentanwälte PartG mbB
(86) International application number: PCT/JP2022/013299
(87) International publication number: WO 2022/264595

(57) **Abstract**

It is possible to accurately grasp the state of a circuit breaker by diagnosis using a sound. An acoustic diagnosis device extracts a first feature amount of an acoustic signal in which a delay of an acoustic signal collected by a microphone is corrected, the delay being generated from a relative distance between the circuit breaker and the microphone, during a normal operation of the circuit breaker for various events of the circuit breaker, and creates a plurality of event models for managing data regarding the first feature amount of the corrected acoustic signal. The acoustic diagnosis device extracts a second feature amount of an acoustic signal in which a delay of an acoustic signal collected by the microphone is corrected, the delay being generated from a relative distance between the circuit breaker and the microphone, during diagnosis of the circuit breaker, calculates a similarity between the second feature amount of the acoustic signal during the diagnosis and the first feature amount in the plurality of event models for each time, estimates the time at which the similarity becomes highest, as an occurrence timing of each event, and diagnoses the circuit breaker from a plurality of estimated occurrence timings.

## Description

### Technical Field

The present invention relates to a technique of acoustic diagnosis of a circuit breaker.

### Background Art

There is an increasing need to perform maintenance without dispatching an operator by remotely monitoring the state of a circuit breaker. In order to respond to this need, a method in which various sensors for grasping an operation state of a circuit breaker are attached to the circuit breaker, and a state is diagnosed from a difference from a normal state has been proposed. In such diagnosis, it has been attempted to monitor the state by installing a current sensor inside the circuit breaker or attaching an acceleration sensor to a casing of the circuit breaker.

In a newly-provided circuit breaker, such a sensor for the purpose of monitoring can be attached from the design stage, but attaching the sensor to an existing circuit breaker in a retrofitting manner causes an increase in cost of the sensor itself and an increase in processing cost associated with the attachment. Furthermore, depending on the type of sensor, it may be difficult to perform the attachment to the casing of the circuit breaker. In particular, when the sensor needs to be attached inside the circuit breaker, the mounting may not be possible. Therefore, it is considered that measurement using a sound that can be measured in a non-contact manner is effective.

PTL 1 discloses a sound detector and a diagnosis device. The sound detector is configured to detect a sound emitted by an AC circuit breaker when the AC circuit breaker is switched on and off. The diagnosis device diagnoses whether or not the AC circuit breaker that has emitted the sound is abnormal based on the sound detected by the sound detector and predetermined determination reference information.

### Citation List

### Patent Literature

PTL 1: JP 2019-184341 A

### Summary of Invention

### Technical Problem

In PTL 1, determination of normality or abnormality is performed by comparing sound information, and a timing of an event that is important for an operation of the circuit breaker is not considered, for example, a timing of moving or separating a contact point by an on/off operation of the circuit breaker, a timing of ending an operation of the contact point, and the like. Therefore, it is not possible to accurately grasp a state in which the operation is gradually performed or the timing of the event changes.

In addition, since the operation of the circuit breaker is completed in tens of milliseconds, it is necessary to extract the timing of the event of the circuit breaker in a very short time, for example, within tens of milliseconds. However, since the speed of an acoustic signal propagates at the sound speed, it is not possible to ignore a delay due to a distance between a microphone that collects the acoustic signal and the circuit breaker.

An object of the present invention is to realize an acoustic diagnosis device and a method capable of accurately grasping a state of a circuit breaker by diagnosis using a sound.

### Solution to Problem

According to an aspect of the present invention, a diagnosis device includes a microphone that converts sound pressure from a circuit breaker into an electrical signal, and an A/D converter that converts the sound pressure converted into the electric signal by the microphone into a digital value at a predetermined cycle to obtain an acoustic signal. The acoustic diagnosis device further includes a central processing unit and a storage device. The central processing unit extracts a first feature amount of an acoustic signal in which a delay of an acoustic signal collected by the microphone is corrected, the delay being generated from a relative distance between the circuit breaker and the microphone, during a normal operation of the circuit breaker for various events of the circuit breaker, and creates a plurality of event models for managing data regarding the first feature amount of the corrected acoustic signal. The storage device stores the plurality of event models. The central processing unit extracts a second feature amount of an acoustic signal in which the delay of an acoustic signal collected by the microphone is corrected, the delay being generated from the relative distance between the circuit breaker and the microphone, during diagnosis of the circuit breaker, calculates a similarity between the second feature amount of the acoustic signal during the diagnosis and the first feature amount in the plurality of event models stored in the storage device for each time, estimates the time at which the similarity becomes highest, as an occurrence timing of each event, and diagnoses the circuit breaker from a plurality of estimated occurrence timings.

### Advantageous Effects of Invention

According to one aspect of the present invention, it is possible to realize an acoustic diagnosis device that accurately diagnoses the state of a circuit breaker by diagnosis using a sound.

### Brief Description of Drawings

[FIG. 1] FIG. 1 is a diagram illustrating an example of a block diagram illustrating a configuration of an acoustic diagnosis device.
[FIG. 2] FIG. 2 is a diagram illustrating an example of measurement at a time of model generation.
[FIG. 3] FIG. 3 is a diagram for describing an example of a model generation process and a diagnosis process.
[FIG. 4] FIG. 4 is a diagram for describing an example of a feature amount extraction process.
[FIG. 5] FIG. 5 is a diagram for describing an example of estimation of an event timing.
[FIG. 6] FIG. 6 is a diagram illustrating an example of stored data of each event model.
[FIG. 7] FIG. 7 is a diagram illustrating an example of stored data of an event model using a Gaussian mixture model for similarity calculation.
[FIG. 8] FIG. 8 is a diagram illustrating an example of diagnosis parameters.

### Description of Embodiments

In an embodiment, in an acoustic diagnosis device that diagnoses a state of a circuit breaker from an acoustic signal, an event model is created from a feature amount obtained by correcting a delay of a sound from a true value using an electrical sensor in advance and positions of the circuit breaker and a microphone that collects the acoustic signal. The feature amount of the acoustic signal is a timing synchronized with the true value using the electrical sensor by correcting the delay. When the circuit breaker is diagnosed, various timings at the time of opening/closing operations of the circuit breaker are accurately estimated in consideration of a delay of the acoustic signal from the microphone that collects the acoustic signal and distance information of the circuit breaker, and the operating state of the circuit breaker is diagnosed based on the estimated timings.

For example, in one embodiment, the acoustic diagnosis device corrects the delay of the acoustic signal with a microphone whose distance to the circuit breaker is known, and synchronously collects an acoustic signal in which the delay is corrected and a measurement value by a current sensor or a laser displacement meter that directly measures a stroke of the circuit breaker. Here, a true value used during diagnosis is estimated from a sensor other than the acoustic signal. On the other hand, a plurality of event models for calculating and correcting the delay of an acoustic signal from the distance between the circuit breaker and the microphone, determining the feature amount of the corrected acoustic signal, and estimating various event timings of the circuit breaker are created in advance. Each event model is data regarding the feature amount of the acoustic signal for comparison at the same timing as the true value of the sensor other than the acoustic signal, during the normal operation of the circuit breaker. During the diagnosis, the delay of transmission of the acoustic signal is corrected based on positional information of the microphone and positional information of the circuit breaker, and the similarity between the feature amount of the corrected acoustic signal and each event model is calculated. The timing of the feature amount at which the similarity becomes highest is estimated as the timing of each event. The state of the circuit breaker is diagnosed by using a diagnosis parameter from the estimated interval of each event or the like. One of the characteristics is that it is possible to determine whether or not the circuit breaker normally operates by diagnosing whether a plurality of important operations are performed at a predetermined timing, and this timing is used as information for diagnosis.

Examples will be described below with reference to the drawings.

### Example 1

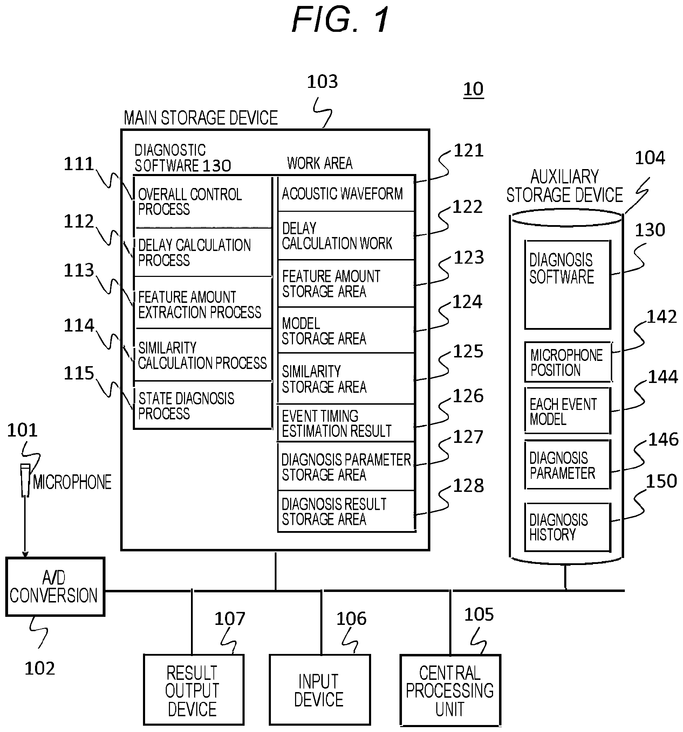

A configuration of an acoustic diagnosis device of a first embodiment will be described with reference to FIG. 1.

As illustrated in FIG. 1, an acoustic diagnosis device 10 includes not only a microphone 101 that converts sound pressure from a circuit breaker into an electrical signal, and an A/D conversion 102 that converts the electric signal (sound pressure) from the microphone into a digital data string, but also a main storage device 103, an auxiliary storage device 104, a central processing unit 105, an input device 106, and a result output device 107 as in a general information processing device.

The auxiliary storage device 104 stores each event model 144 in consideration of a delay of an acoustic signal due to an electrical sensor and a microphone position, information for obtaining a relative distance between the microphone and the circuit breaker, for example, positional information 142 of the microphone, a diagnosis parameter 146 for performing diagnosis from a timing of each event, diagnostic software 130, and a diagnosis history 150.

The event of the circuit breaker is a timing at which an important event is performed, for example, a timing of moving or separating a contact point by an on/off operation of the circuit breaker, a timing of ending an operation of the contact point, and the like. The operation of the circuit breaker is completed in tens of milliseconds, and is performed in a very short time, for example, within the tens of milliseconds. Therefore, it is necessary to grasp and correct the delay of the acoustic signal due to the distance between the circuit breaker and the microphone.

Each event model 144 manages data regarding the feature amount of the corrected acoustic signal, for each event, in a state where the circuit breaker is normal. For example, there are an average value of a feature amount vector of the acoustic signal in various events of the circuit breaker, the median value of the distribution of the feature amount vector, and a feature amount that is actually observed in the vicinity thereof. When the feature amount vector does not have a simple distribution, for example, a Gaussian mixture model can be used as the likelihood for the event model.

The current positional information 142 of the microphone for measurement is information indicating a relative distance between the circuit breaker and the microphone. When the installation position of the circuit breaker is known in advance as the coordinate position, the coordinate positional information of the microphone may be used.

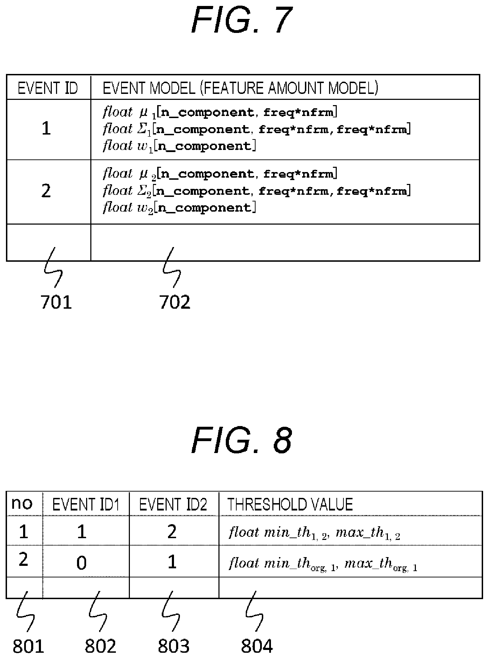

The diagnosis parameter 146 is data for diagnosing the state of the circuit breaker, and may be given as, for example, a threshold such as the minimum value or the maximum value of an interval between events of the circuit breaker. In this case, if the timing of the event estimated from the feature amount of the acoustic signal is within a range from the minimum value to the maximum value of the event interval, it can be determined that the operation is normal. In the present example, one of the characteristics focuses on that it is possible to determine whether or not the operation is normally performed by diagnosing whether a plurality of important operations are performed at a predetermined timing. The diagnosis parameter will be described later with reference to FIG. 8.

In the main storage device 103, diagnostic software 130 that executes an overall control process 111, a delay calculation process 112, a feature amount extraction process 113, a similarity calculation process 114, and a state diagnosis process 115 is read from the auxiliary storage device 104 and stored. The main storage device 103 includes, as work areas required by the diagnostic software 130, an acoustic waveform storage area 121, a delay calculation work area 122, a feature amount storage area 123, a model storage area 124, a similarity storage area 125, an event timing estimation result 126, a diagnosis parameter storage area 127, and a diagnosis result storage area 128.

The central processing unit 105 executes a program on the main storage device. The input device 106 inputs a parameter such as a microphone position, and the result output device 107 outputs a result.

The delay calculation process 112 calculates, as a delay amount, a difference in timing between an electrical sensor such as a current sensor, a vibration sensor, or a laser displacement meter and an acoustic signal of the microphone for various events of the circuit breaker.

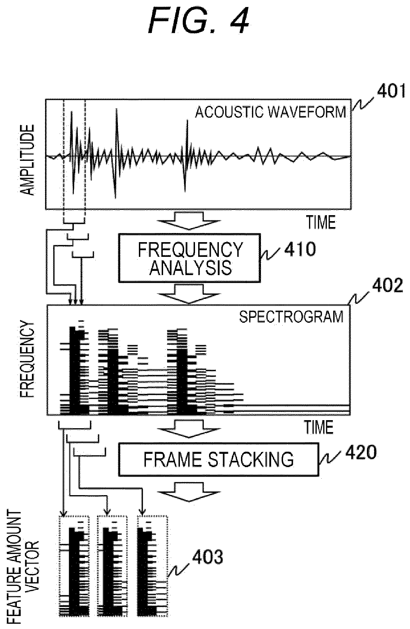

The feature amount extraction process 113 is a process of extracting an average value of feature amounts of the acoustic signal or a feature amount present in the vicinity of the center of the distribution of the feature amounts, for various events of the circuit breaker, based on the acoustic signal in which the delay has been corrected. The feature amount extraction process will be described later with reference to FIG. 4.

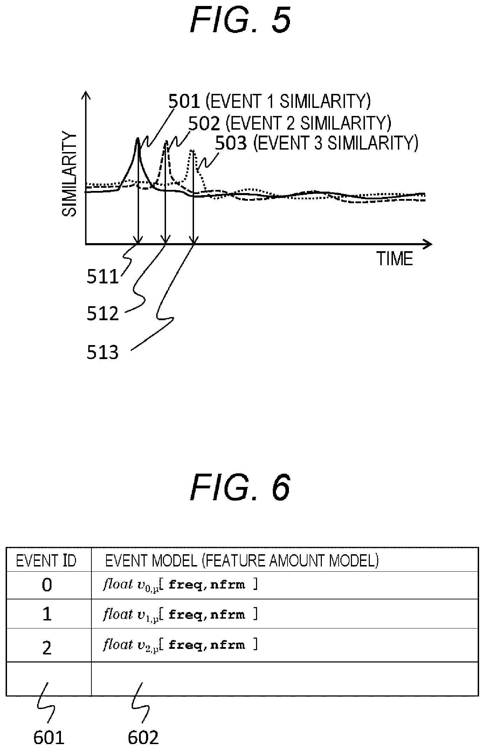

The similarity calculation process 114 calculates the similarity between the feature amount of the acoustic signal measured during the diagnosis and the feature amount of the event model 144, for each time. Specifically, the occurrence time of each event is obtained from the maximum value of the similarity between the measured feature amount of the acoustic signal and the feature amount of the event model 144, and is stored as the event timing estimation result 126. The event timing estimation process by the similarity calculation process will be described later with reference to FIG. 5.

In the state diagnosis process 115, the state of the circuit breaker is diagnosed based on the diagnosis parameter from each event timing estimated in the similarity calculation process 114.

The acoustic waveform storage area 121 is an area for storing an acoustic signal collected from the microphone 101.

The delay calculation work area 122 is a work area for the delay calculation process (112) to calculate the delay of the acoustic signal by the microphone 101.

The feature amount storage area 123 is an area for storing the feature amount of the acoustic signal extracted by the feature amount extraction process 113.

The model storage area 124 is a storage area for storing the feature amount of the acoustic signal in various events of the circuit breaker as an event model. An example of the event model will be described later with reference to FIGS. 6 and 7.

The similarity storage area 125 is an area for storing a calculation result by the similarity calculation process 114.

The event timing estimation result 126 is an area for storing the event timing estimation result by the similarity calculation process 114.

The diagnosis parameter storage area 127 is an area for storing the diagnosis parameter used in the state diagnosis process 115.

The diagnosis result storage area 128 is an area for storing a diagnostic result of the circuit breaker by the state diagnosis process 115.

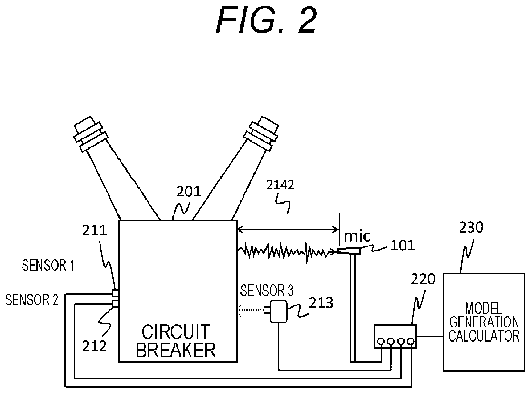

FIG. 2 is a diagram illustrating an example of measurement at a time of model generation in Example 1.

First, the acoustic diagnosis device synchronizes a true value of a sensor 211, 212, or 213 such as an electrical sensor such as a current sensor, a vibration sensor, or a laser displacement meter, other than an acoustic signal, with the acoustic signal of the microphone 101 to correct the delay of the acoustic signal. The event model 144 in various events of the circuit breaker at the normal time is generated with the feature amount of the corrected acoustic signal.

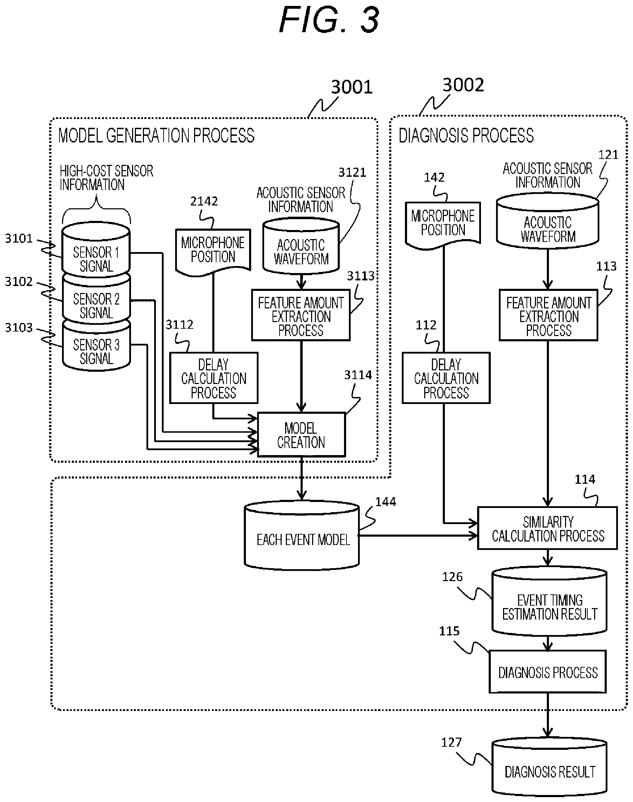

In order to accurately obtain the timing of the on/off operation of a circuit breaker 201, an electrical sensor 211, 212, or 213 such as a current sensor, a vibration sensor, or a laser displacement meter is installed in the circuit breaker 201. A logger 220 has a function of A/D converting an acoustic signal during the operation of the circuit breaker 201, which is collected by the microphone 101, and the signal of the sensor 211, 212, or 213, and the logger 220 synchronizes the signals of the electrical sensor 211, 212, or 213 and the microphone 101 with each other to convert the signals into digital signals. A model generation calculator 230 that generates each event model 144 is connected by using a distance 2142 between the circuit breaker 201 and the microphone 101. A model generation process 3001 in FIG. 3 is executed by the model generation calculator 230 to create each event model 144. The model generation calculator 230 mainly corresponds to the processes of the delay calculation process 112 and the feature amount extraction process 113 of FIG. 1. The model generation calculator 230 corrects the delay of the acoustic signal collected by the microphone 101, and creates each event model with the feature amount of the acoustic signal at the normal time of various events of the circuit breaker 201.

FIG. 3 is a diagram for explaining the model generation process 3001 executed by the model generation calculator 230 and a diagnosis process 3002 by the diagnostic software 130.

First, the model generation process 3001 for generating the event model with the feature amounts of the acoustic signals of various circuit breakers at a timing of an important event such as a timing of moving or separating a contact point by an on/off operation of the circuit breaker, and a timing of ending an operation of the contact point will be described. The event model generation process 3001 is mainly processed by the delay calculation process 112 and the feature amount extraction process 113 in FIG. 1.

A sensor signal 1 3101, a sensor signal 2 3102, and a sensor signal 3 3103 correspond to the electrical sensors 211, 212, and 213 illustrated in FIG. 2, and detect the vibration, the operation, and the like of the circuit breaker, which are generated by various events of the circuit breaker without the delay. On the other hand, the acoustic signal collected from the microphone 101 is delayed by the distance between the circuit breaker 201 and the microphone. Regarding this delay, a delay amount with the electrical sensor 3101, 3102, or 3103 is obtained with the sound speed by a delay calculation process 3112, and timings of the acoustic signal and the signal of the electrical sensor are synchronized with each other.

The acoustic signal collected by the microphone 101 is stored as acoustic sensor information (acoustic waveform 121) 3121. In the stored acoustic signal, a feature amount is extracted by a feature amount extraction process 3113. In consideration of the delay of the acoustic signal, the event model can be generated from the feature amount of the acoustic signal at the normal time at the timing synchronized with the electrical sensors 3101, 3102, and 3103. For example, at the normal time, what kind of feature amount the acoustic signal collected from the microphone has at the timing of an important event such as a timing of moving or separating a contact point by an on/off operation of the circuit breaker, and a timing of ending an operation of the contact point is stored as the event model. In FIG. 3, the feature amount is extracted from the acoustic signal collected by the microphone, the delay of the acoustic signal is input to model generation 3114 in the delay calculation process 3112, and the model 144 of each event is generated from the feature amount of the acoustic signal synchronized with the electrical sensors 3101, 3102, and 3103. However, after the delay calculation process 3112 is performed, the delay may be input to the feature amount extraction process 3113 and the feature amount may be obtained from the acoustic signal in which the delay is corrected.

In the event model creation, an event model is created for each of various events of the circuit breaker 201. Therefore, an event ID for identifying an event is assigned to each of the various events, and an event model is generated for each event ID. The event model is managed as an event model correspondence table as illustrated in FIG. 6 to be described later.

FIG. 4 is a diagram for explaining the feature amount extraction process 3113 illustrated in FIG. 3.

An acoustic waveform 401 is subjected to frequency analysis 410 to generate a spectrogram 402 as a time series of a short-time spectrum. At this time, the stride of a window when the short-time spectrum is calculated is set to a time shorter than 1 ms. A necessary frequency range is extracted from the obtained short-time spectrum, a plurality of frames are stacked, and a feature amount is extracted as a feature amount vector 403. When the feature amount is generated from the acoustic signal in which the delay is corrected, the feature amount from the corrected acoustic signal is obtained in a manner that the time of the spectrogram 402 is shifted by the delay calculated by the delay calculation process 112. Alternatively, when the event model is created from the feature amount vector 403, the event model may be created by shifting the delay calculated by the delay calculation process 112.

The diagnosis process 3002 in FIG. 3 will be described. The diagnosis process 3002 is mainly processed by the delay calculation process 112, the feature amount extraction process 113, the similarity calculation process 114, and the state diagnosis process 115 in FIG. 1. The acoustic signal collected by the microphone 101 is stored as acoustic sensor information (acoustic waveform 121), and a feature amount is extracted by the feature amount extraction process 113. A feature amount extraction procedure is performed in the same procedure as the model generation process 3001.

The delay of the acoustic signal is calculated by the delay calculation process 112 from the position 142 of the microphone during the diagnosis. In the similarity calculation process 114, the similarity is calculated by comparing each event model with the feature amount of the acoustic signal during the diagnosis, by using the model stored in each event model 144. The acoustic signal collected by the microphone 101 during the diagnosis is subjected to the delay calculation process 112 of calculating the delay of the acoustic signal based on the relative position between the microphone 101 and the circuit breaker 201, and is input to the similarity calculation process 114. In the similarity calculation process 114, the feature amount extracted from the acoustic signal during the diagnosis is shifted by the delay of the delay calculation process 112 and is compared with the feature amount of each event model 144. As illustrated in FIG. 5, this comparison is performed every time. The occurrence time of each event is obtained from the maximum value of the similarity for each event, and the delay is corrected to obtain the event timing estimation result.

It can be determined whether or not the circuit breaker normally operates by diagnosing whether the timing of the important operation is performed at a predetermined timing.

FIG. 5 is a diagram for describing the estimation of the event timing.

In FIG. 5, the horizontal axis represents the time, and the vertical axis represents the similarity calculated by the similarity calculation process 114 in FIG. 3. The similarity is obtained by comparing the event model with the acoustic signal of the circuit breaker to be diagnosed. When the event model is similar to the acoustic signal of the circuit breaker to be diagnosed, a value of the similarity is large. For Event 1, Event 2, and Event 3 of the circuit breaker, by comparing the event model for each event with the feature amount of the acoustic signal of a diagnostic machine to be diagnosed, it is possible to grasp the timing at which the similarity is maximum and the occurrence time of each event.

For example, the occurrence time of Event 1 can be estimated as a time 511, the occurrence time of Event 2 can be estimated as a time 512, and the occurrence time of Event 3 can be estimated as a time 513.

As described above, it is possible to accurately estimate the occurrence timing of each event by considering the delay of the acoustic signal, performing synchronization with the electrical sensor 3101, 3102, or 3103, comparing the event model at the normal time with the feature amount of the acoustic signal during the diagnosis, and calculating the similarity. It can be determined whether or not the circuit breaker normally operates by diagnosing whether the timing of the important operation is performed at a predetermined timing. Therefore, in the diagnosis process 115, as illustrated in FIG. 8, a threshold value 804 of a range of the maximum value and the minimum value of the interval between specific events of the circuit breaker is given, as the diagnosis parameter, to the interval between specific events and the time interval from a trigger signal of an event to each event, and the determination is made based on whether or not the interval is within the range. When there is a limit only on one side of the maximum value and the minimum value, for example, no constraint is expressed by setting +∞ to the maximum value and setting -∞ to the minimum value.

FIG. 6 illustrates an example of the expression (event model correspondence table) of the event model of the feature amount for each event. As illustrated in FIG. 6, an event ID for identifying each event and each event model are managed in association with each other. The event model illustrated in FIG. 6 can be implemented when the feature amount corresponding to the event is stable, and is expressed by one representative value of a simple feature amount. This can be calculated, for example, by using the median value or the average value of the distribution at the time of model creation. The similarity can be calculated by a cosine distance or a Euclidean distance.

### Example 2

FIG. 7 illustrates an example when the event model is expressed by the Gaussian mixture model as the feature amount for each event. A feature amount model 602 is managed as the event model in association with each event ID 601. An average value of n_component pieces of feature amounts, a covariance matrix, and a weight ω are included, and likelihood is calculated for each time, whereby the similarity is regarded.

A reference point appropriately disposed on a feature amount space and a model parameter obtained by quantifying the state corresponding to data in the vicinity of a feature point with respect to the reference point may be prepared for the relationship between the feature amount extracted from measurement data in advance and the state of the device at the time of measurement.

### Reference Signs List

- 101: microphone
- 102: A/D conversion
- 103: main storage device
- 104: auxiliary storage device
- 105: central processing unit
- 106: input device
- 107: result output device
- 111: overall control process
- 112: delay calculation process
- 113: feature amount extraction process
- 114: similarity calculation process
- 121: acoustic waveform
- 122: delay calculation work
- 123: feature amount storage area
- 124: model storage area
- 125: similarity storage area
- 126: event timing estimation result
- 127: diagnosis parameter storage area
- 128: diagnosis result storage area
- 130: diagnostic software
- 142: microphone position
- 144: each event model
- 146: diagnosis parameter
- 150: diagnosis history
- 201: circuit breaker
- 211: electrical sensor 1
- 212: electrical sensor 2
- 213: electrical sensor 3
- 2142: microphone position
- 220: logger
- 230: model generation calculator
- 3001: model generation process
- 3002: diagnosis process
- 3101: sensor signal 1
- 3102: sensor signal 2
- 3103: sensor signal 3
- 3112: delay calculation process
- 3121: acoustic waveform
- 3113: feature amount extraction process
- 3114: model creation
- 401: acoustic waveform
- 402: spectrogram
- 403: feature amount vector
- 410: frequency analysis
- 420: frame stacking
- 501: event 1 similarity
- 502: event 2 similarity
- 503: event 3 similarity
- 511: event 1 timing estimation value
- 512: event 2 timing estimation value
- 513: event 3 timing estimation value
- 601: event ID
- 602: feature amount model
- 702: feature amount model (Gaussian mixture model)
- 801: diagnosis parameter number
- 802: diagnosis event ID No. 1
- 803: diagnosis event ID No. 2
- 804: diagnosis threshold value information

## Claims

1. An acoustic diagnosis device comprising:
a microphone that converts a sound pressure from a circuit breaker into an electrical signal;
an A/D converter that converts the sound pressure converted into the electric signal by the microphone into a digital value at a predetermined cycle to obtain an acoustic signal;
a central processing unit; and
a storage device,
wherein the central processing unit
extracts a first feature amount of an acoustic signal in which a delay of an acoustic signal collected by a microphone is corrected, the delay being generated from a relative distance between the circuit breaker and the microphone, during a normal operation of the circuit breaker for various events of the circuit breaker, and
creates a plurality of event models for managing data regarding the first feature amount of the corrected acoustic signal for each event,
the storage device stores the plurality of event models, and
the central processing unit
extracts a second feature amount of an acoustic signal in which a delay of an acoustic signal collected by the microphone is corrected, the delay being generated from the relative distance between the circuit breaker and the microphone, during diagnosis of the circuit breaker,
calculates a similarity between the second feature amount of the acoustic signal during the diagnosis and the first feature amount in the plurality of event models stored in the storage device for each time,
estimates the time at which the similarity becomes highest, as an occurrence timing of each event, and
diagnoses the circuit breaker from a plurality of estimated occurrence timings.

2. The acoustic diagnosis device according to claim 1, wherein the central processing unit synchronizes a signal input from an electrical sensor provided in the circuit breaker with a digital value of the microphone, and calculates the delay of the acoustic signal collected by the microphone with respect to the signal input from the electrical sensor.

3. The acoustic diagnosis device according to claim 1, wherein the plurality of event models stored in the storage device manages the event model obtained by extracting the first feature amount of the acoustic signal in which the delay of the acoustic signal collected by the microphone is corrected, the delay being generated from the relative distance between the circuit breaker and the microphone, in association with a vent ID for identifying various events of the circuit breaker.

4. The acoustic diagnosis device according to claim 3, wherein the event model stored in the storage device manages the feature amount indicated by a Gaussian mixture model in association with each event.

5. The acoustic diagnosis device according to claim 1, wherein the feature amount of the acoustic signal extracted by the central processing unit is an average value of feature amount vectors of the acoustic signal.

6. The acoustic diagnosis device according to claim 1, wherein the feature amount of the acoustic signal extracted by the central processing unit is a median value of a distribution of feature amount vectors of the acoustic signal.

7. The acoustic diagnosis device according to claim 1, wherein
the storage device stores a diagnosis parameter that manages a maximum value and a minimum value of an interval between specific events of the circuit breaker as threshold values, and
the central processing unit diagnoses the circuit breaker based on the plurality of estimated occurrence timings and the diagnosis parameter.

8. An acoustic diagnosis device comprising:
a microphone that converts a sound pressure from a circuit breaker into an electrical signal;
an A/D converter that converts the sound pressure converted into the electric signal by the microphone into a digital value at a predetermined cycle to obtain an acoustic signal;
a first feature amount extraction processing unit that extracts a feature amount of an acoustic signal in which a delay of an acoustic signal collected by a microphone is corrected, the delay being generated from a relative distance between the circuit breaker and the microphone, during a normal operation of the circuit breaker for various events of the circuit breaker;
a model creation unit that creates a plurality of event models for managing data regarding the feature amount of the corrected acoustic signal for each event;
an event model storage unit that stores the plurality of event models;
a second feature amount extraction processing unit that extracts a feature amount of an acoustic signal in which a delay of an acoustic signal collected by the microphone is corrected, the delay being generated from the relative distance between the circuit breaker and the microphone, during diagnosis of the circuit breaker;
a similarity calculation processing unit that calculates a similarity between the feature amount of the acoustic signal during the diagnosis and the feature amount in the plurality of event models stored in the event model storage unit for each time, and estimates the time at which the similarity becomes highest, as an occurrence timing of each event; and
a diagnosis processing unit that diagnoses the circuit breaker based on a plurality of the estimated occurrence timings.

9. An acoustic diagnosis method of an acoustic diagnosis device including a microphone that converts a sound pressure from a circuit breaker into an electrical signal, and an A/D converter that converts the sound pressure converted into the electric signal by the microphone into a digital value at a predetermined cycle to obtain an acoustic signal, the acoustic diagnosis method comprising:
extracting a feature amount of an acoustic signal in which a delay of an acoustic signal collected by a microphone is corrected, the delay being generated from a relative distance between the circuit breaker and the microphone, during a normal operation of the circuit breaker for various events of the circuit breaker, by a central processing unit of the acoustic diagnosis device;
creating a plurality of event models for managing data regarding the feature amount of the corrected acoustic signal for each event;
storing the plurality of event models created by the central processing unit, by a storage device of the acoustic diagnosis device;
extracting a feature amount of an acoustic signal in which a delay of an acoustic signal collected by the microphone is corrected, the delay being generated from the relative distance between the circuit breaker and the microphone, during diagnosis of the circuit breaker, by the central processing unit;
calculating a similarity between the feature amount of the acoustic signal during the diagnosis and the feature amount in the plurality of event models stored in the storage device for each time, and performing an event timing estimation of estimating the time at which the similarity becomes highest, as an occurrence timing of each event; and
diagnosing the circuit breaker based on a plurality of estimated occurrence timings.
